(19) Europäisches Patentamt
European Patent Office
Office européen des brevets

(11) **EP 4 002 431 B1**

(12) **FASCICULE DE BREVET EUROPEEN**

(45) Date de publication et mention
de la délivrance du brevet:
**21.08.2024 Bulletin 2024/34**

(51) Classification Internationale des Brevets (IPC):
**H01L 21/302** [(2006.01)]     **H01L 21/306** [(2006.01)]

(21) Numéro de dépôt: **21208567.4**

(22) Date de dépôt: **16.11.2021**

(52) Classification Coopérative des Brevets (CPC):
**H01L 21/302; H01L 21/02002; H01L 21/30621**

(54) **PROCÉDÉ DE PLANARISATION D'UN SUBSTRAT SEMICONDUCTEUR**

PLANARTECHNIK FÜR EIN HALBLEITERSUBSTRAT

METHOD FOR PLANARIZING A SEMICONDUCTOR SUBSTRATE

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **19.11.2020 FR 2011912**

(43) Date de publication de la demande:
**25.05.2022 Bulletin 2022/21**

(73) Titulaire: **Commissariat à l'Énergie Atomique
et aux Énergies Alternatives
75015 Paris (FR)**

(72) Inventeurs:
• **REBOH, Shay
38054 GRENOBLE CEDEX 09 (FR)**

• **HARTMANN, Jean-Michel
38054 GRENOBLE CEDEX 09 (FR)**
• **MAZEN, Frederic
38054 GRENOBLE CEDEX 09 (FR)**
• **MILESI, Frédéric
38054 GRENOBLE CEDEX 09 (FR)**

(74) Mandataire: **Cabinet Beaumont
4, Place Robert Schuman
B.P. 1529
38025 Grenoble Cedex 1 (FR)**

(56) Documents cités:
**EP-A1- 0 615 004     WO-A1-2014/037410
JP-A- H03 190 233     US-A1- 2018 350 612**

**Description**

Domaine technique

La présente description concerne de façon générale le domaine de la microélectronique, et vise plus particulièrement un procédé de polissage d'un substrat semiconducteur.

Technique antérieure

De façon classique, dans le domaine de la microélectronique, il est connu d'éliminer des structurations de surface ou de réduire la rugosité d'un substrat semiconducteur par des procédés d'abrasion mécanique de type polissage mécano-chimique (CMP), ou polissage par bombardement ionique.

Les documents WO 2014/037410, US 2018/350612 et JP H03 190233 proposent de telles procécedés.

Il serait souhaitable d'améliorer au moins en partie certains aspects des procédés de polissage connus.

Résumé de l'invention

Pour cela, un mode de réalisation prévoit un procédé de polissage d'un substrat semiconducteur, comprenant :

a) une étape d'implantations multiples d'ions à partir d'une face supérieure du substrat, de façon à modifier le matériau d'une partie supérieure du substrat, l'étape d'implantations multiples comprenant plusieurs implantations successives sous des orientations d'implantation respectives différentes ; et

b) une étape de retrait sélectif de la partie supérieure du substrat.

Selon un mode de réalisation, les implantations successives mises en oeuvre à l'étape a) sont réalisées avec une même profondeur d'implantation dans une direction normale au plan moyen du substrat.

Selon un mode de réalisation, l'étape a) comprend plusieurs implantations successives sous des angles d'incidence respectifs distincts et avec des énergies d'implantations respectives distinctes.

Selon un mode de réalisation, l'étape a) comprend plusieurs implantations successives sous un même angle d'incidence et avec une même énergie d'implantation, sous des angles respectifs différents dans un plan parallèle au plan moyen du substrat.

Selon un mode de réalisation, à l'étape a), l'angle d'implantation, dans un plan parallèle au plan moyen du substrat, varie de façon continue.

Selon un mode de réalisation, à l'étape a), l'angle d'incidence d'implantation varie de façon continue.

Selon un mode de réalisation, le substrat est un substrat monocristallin.

Selon un mode de réalisation, l'étape a) conduit à rendre amorphe ladite partie supérieure du substrat.

Selon un mode de réalisation, le procédé comprend en outre, après l'étape a), une étape de recristallisation en phase solide d'une partie inférieure de ladite partie supérieure du substrat.

Selon un mode de réalisation, l'étape de recristallisation en phase solide est mise en oeuvre avant l'étape b).

Selon un mode de réalisation, l'étape de recristallisation en phase solide est mise en oeuvre conjointement à l'étape b).

Selon un mode de réalisation, l'étape a) conduit à doper la partie supérieure du substrat en conservant sa structure monocristalline.

Selon un mode de réalisation, les ions implantés à l'étape a) sont des ions du groupe comprenant l'azote, l'oxygène, le fluor, le silicium, l'argon, le germanium, le xénon, le carbone et le phosphore.

Selon un mode de réalisation, à l'étape b), le retrait sélectif de la partie supérieure du substrat est réalisé par un procédé de gravure thermique à l'aide d'un mélange gazeux.

Selon un mode de réalisation, le mélange gazeux contient du chlore.

Selon un mode de réalisation, le substrat semiconducteur est en silicium, et le mélange gazeux est un mélange à base d'acide chlorhydrique et de germane, avec un éventuel flux additionnel de dihydrogène.

Selon un mode de réalisation, à l'étape a), les conditions d'implantation sont choisies adaptées à entraîner une abrasion mécanique de la face supérieure du substrat.

Selon un mode de réalisation, à l'étape a), les implantations multiples n'entraînent pas d'abrasion mécanique de la face supérieure du substrat.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 est une vue en coupe schématique et partielle illustrant une étape d'implantation d'ions dans un substrat semiconducteur ;

la figure 2 est une vue en coupe schématique et partielle illustrant une étape d'un exemple d'un procédé de polissage d'un substrat semiconducteur selon un mode de réalisation ;

la figure 3 est une vue en coupe schématique et partielle illustrant une autre étape d'un exemple d'un procédé de polissage d'un substrat semiconducteur selon un mode de réalisation ;

la figure 4 est une vue en coupe schématique et partielle illustrant une étape d'une variante d'un procédé de polissage d'un substrat semiconducteur selon un mode de réalisation ; et

la figure 5 est une vue en coupe schématique et partielle illustrant une étape d'une autre variante d'un procédé de polissage d'un substrat semiconducteur selon un mode de réalisation.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les applications qui peuvent être faites des procédés de polissage décrits ci-après n'ont pas été détaillées, les modes de réalisation décrits étant compatibles avec toutes ou la plupart des applications pouvant tirer profit du polissage d'un substrat semiconducteur.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

A titre d'exemple non limitatif, les procédés de polissage décrits ci-après peuvent être utilisés pour réduire la rugosité de surface d'une couche semiconductrice transférée depuis un substrat semiconducteur de départ ou substrat donneur sur un substrat de destination ou substrat receveur, par un procédé de type Smart-Cut™. Dans un tel procédé, le substrat de départ peut être un substrat monocristallin, par exemple en silicium. A titre d'exemple, le substrat de départ est en forme de plaque ayant deux faces principales opposées. Des espèces, par exemple des ions d'hydrogène ou d'hélium, sont implantés à partir d'une première face principale du substrat de manière à former une couche fragile, par exemple une couche hydrogénée, enterrée dans le substrat. La partie du substrat de départ située entre la couche fragile enterrée et la première face principale (ou face d'implantation) est destinée à être transférée sur le substrat de destination. Préalablement à l'implantation, une couche électriquement isolante, par exemple en oxyde de silicium, peut être formée sur la première face principale du substrat de départ. Le substrat de destination peut lui aussi être un substrat en forme de plaque ayant deux faces principales opposées. A titre d'exemple, le substrat de destination est en un matériau semiconducteur, par exemple en silicium. Une couche électriquement isolante, de préférence en le même matériau que la couche électriquement isolante formée sur la face d'implantation du substrat de départ, peut être formée sur une première face principale du substrat de destination. On recouvre ensuite la première face principale du substrat de départ par le substrat de destination. A titre d'exemple, on assemble pour cela les couches isolantes formées respectivement sur la première face principale du substrat de départ et sur la première face principale du substrat de destination, en mettant en contact leurs faces restées accessibles, c'est-à-dire non recouvertes. De préférence, l'assemblage est de type collage direct, encore appelé collage moléculaire. Les modes de réalisation décrits ne se limitent toutefois pas à ce cas particulier. On procède ensuite à un traitement thermique et/ou mécanique de manière à provoquer une fracturation le long de la couche fragile enterrée. Ainsi, seule une couche du substrat de départ, correspondant à la partie du substrat de départ située entre la face d'implantation et la couche fragile enterrée, subsiste sur le substrat de destination. Un polissage de la face restée accessible de la couche transférée est ensuite mis en oeuvre pour réduire les rugosités de surface résultant de la fracturation de la couche fragile enterrée. Les procédés de polissage décrits ci-après sont tout particulièrement adaptés à la mise en oeuvre de ce polissage.

Plus généralement, les procédés de polissage décrits ci-après peuvent être utilisés pour toute application pouvant tirer profit d'un polissage d'un substrat semiconducteur présentant des structurations de surface. Les structurations à retirer peuvent être périodiques, par exemple fabriquées volontairement par un procédé de structuration de surface, ou non-périodiques, par exemple distribuées aléatoirement, ce qui est par exemple le cas des structurations de surface résultant d'un procédé de type Smart-Cut™. A titre d'exemple, la hauteur des structurations peut être inférieure ou égale à 1 $\mu$m, par exemple comprise entre 10 nm et 1 $\mu$m et de préférence entre 10 nm et 200 nm.

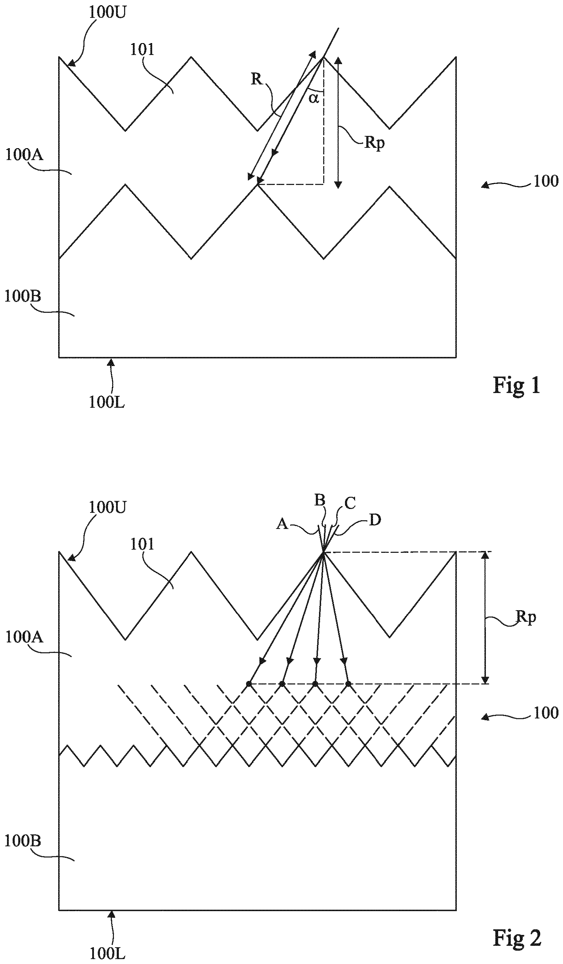

La figure 1 est une vue en coupe schématique et partielle illustrant une étape d'implantation d'ions dans un substrat semiconducteur 100, par exemple un substrat monocristallin, par exemple en silicium. Le substrat 100 est par exemple en forme de plaque comportant deux faces principales opposées 100U et 100L, correspondant respectivement à la face supérieure et à la face inférieure dans l'orientation de la figure 1. Dans cet exemple, le substrat 100 comprend des structurations ou rugosités 101 du côté de sa face supérieure 100U. Sur la figure 1, les structurations 101 sont représentées de façon schématique sous la forme de motifs triangulaires périodiques. Les modes de réalisation décrits ne se limitent toutefois pas à ce cas particulier.

Lors d'une implantation ionique, on peut régler précisément l'énergie donnée aux ions, aussi appelée énergie d'implantation. Il en résulte que les ions pénètrent dans le matériau du substrat jusqu'à une profondeur définie Rp, et ce avec une incertitude latérale et en profondeur définie, appelée dispersion ("straggling" en anglais). Ceci conduit à projeter ou répliquer de façon très conforme les structurations de la face supérieure à l'intérieur du matériau du substrat, en termes de concentration d'ions implantés (à l'incertitude liée à l'implantation près). L'implantation conduit à modifier la nature du matériau du substrat sur toute la partie traversée par les espèces, c'est-à-dire dans une partie supérieure 100A du substrat, impactée par les ions. Le reste du substrat forme une partie inférieure 100B du substrat. Dans la partie inférieure 100B la nature du matériau du substrat reste inchangée.

La modification du matériau du substrat dans la partie supérieure 100A du substrat peut consister en une amorphisation du matériau initialement cristallin du substrat, ou encore à un dopage du matériau cristallin du substrat (par exemple de façon à obtenir une partie supérieure 100A en silicium monocristallin dopé et une partie inférieure 100B en silicium monocristallin non dopé).

Comme l'illustre la figure 1, du fait de la conformité du procédé d'implantation, l'interface entre la partie supérieure modifiée 100A du substrat et la partie inférieure non modifiée 100B du substrat réplique le motif des structurations de la face supérieure 100U du substrat, avec un décalage latéral dépendant de l'angle d'incidence du faisceau d'implantation par rapport au plan moyen du substrat. Plus particulièrement, la face supérieure de la partie inférieure non modifiée 100B du substrat définit un motif similaire à celui de la face supérieure 100U du substrat, avec un décalage latéral dépendant de l'angle d'incidence du faisceau d'implantation, tandis que la face inférieure de la partie supérieure modifiée 100A du substrat définit un motif complémentaire. En d'autres termes, chaque point de la face supérieure du substrat est projeté sur l'interface entre les parties 100A et 100B à une profondeur Rp, avec une translation (décalage latéral) dépendant de l'angle d'incidence du faisceau d'implantation.

En pratique, du fait de la dispersion liées à l'implantation (straggling), chaque point de la surface supérieure du substrat est en réalité projeté sur l'interface entre les parties 100A et 100B sous la forme d'un nuage de points défini par la profondeur d'implantation Rp, l'angle d'incidence du faisceau d'implantation, et la dispersion (straggling). Ainsi, bien qu'une interface nette ait été représentée sur la figure entre les parties 100A et 100B, en pratique, une couche de transition d'épaisseur liée à la dispersion d'implantation s'étend à l'interface entre les parties 100A et 100B.

La figure 2 est une vue en coupe schématique et partielle illustrant une étape d'un exemple d'un procédé de polissage d'un substrat semiconducteur 100 selon un mode de réalisation. Le substrat 100 est par exemple identique ou similaire à ce qui a été décrit ci-dessus en relation avec la figure 1.

Lors de cette étape, on vient implanter des ions à partir de la face supérieure du substrat 100, de façon à modifier la nature du matériau d'une partie supérieure 100A du substrat, de façon similaire à ce qui a été décrit ci-dessus en relation avec la figure 1. A l'issue de cette étape, une partie inférieure 100B du substrat, en contact, par sa face supérieure, avec la face inférieure de la partie 100A, reste inchangée.

L'étape de la figure 2 comprend plus particulièrement plusieurs étapes successives d'implantation ionique avec des orientations d'implantation respectives différentes. A titre d'exemple, l'étape de la figure 2 comprend 3 à 20, et de préférence 4 à 10 étapes d'implantation successives avec des orientations d'implantation respectives différentes. Sur la figure 2, quatre implantations A, B, C et D ont été représentées schématiquement par des demi-droites, avec respectivement quatre angles d'incidence différents.

A chaque étape d'implantation, l'énergie d'implantation est choisie en fonction de l'angle d'incidence $\alpha$, et de la profondeur d'implantation Rp souhaitée (figure 1). L'angle $\alpha$ correspond à l'angle d'incidence du faisceau d'implantation défini par rapport au plan principal ou plan moyen du substrat 100 (horizontal dans les exemples représentés), c'est-à-dire l'angle formé entre le faisceau d'implantation et la normale au plan principal du substrat 100. La profondeur d'implantation Rp est définie comme étant la distance parcourue par les ions à l'intérieur du substrat 100 selon une direction normale au plan principal ou plan moyen du substrat 100 (c'est-à-dire selon une direction verticale dans les exemples représentés). Ainsi, si l'on définit par R la distance parcourue par les ions à l'intérieur du substrat dans la direction d'implantation, la profondeur d'implantation Rp est définie comme suit :

[Math 1]

$$\mathrm{Rp} = R \cos(\alpha)$$

Dans l'exemple de la figure 2, à chaque étape d'implantation, l'énergie d'implantation est choisie de façon que la profondeur d'implantation Rp soit sensiblement la même pour toutes les étapes d'implantation, par exemple comprise entre 1 et 4 fois la hauteur des rugosités 101 à corriger. A titre d'exemple, la profondeur d'implantation Rp est comprise entre 10 nm et 1 $\mu$m, par exemple entre 10 et 200 nm. Comme l'illustre notamment la figure 2, la partie modifiée 100A du substrat forme une couche continue s'étendant sur toute la surface du substrat. Cette couche 100A présente une épaisseur supérieure ou égale à la hauteur des rugosités 101.

De préférence, des ions de même nature sont utilisés lors des différentes étapes d'implantation, par exemple des ions azote, des ions oxygène, des ions fluor, des ions silicium, des ions argon, des ions germanium, des ions xénon, des ions carbone ou des ions phosphore.

Comme l'illustre schématiquement la figure 2, le fait de prévoir plusieurs implantations sous des angles d'incidence différents et à une même profondeur d'implantation permet de réduire la rugosité de l'interface entre les parties supérieure 100A et inférieure 100B du substrat par rapport à la rugosité de la face supérieure du substrat 100. Plus particulièrement, ceci conduit à réduire la hauteur (dimension verticale), la largeur (dimension horizontale) et le pas (espacement horizontal) des structurations à l'interface entre les parties supérieure 100A et inférieure 100B du substrat 100, par rapport respectivement à la hauteur, à la largeur, et au pas des structurations de la face supérieure 100U du substrat 100.

On notera que la figure 2 est une représentation en deux dimensions (vue en coupe) du substrat 100. En pratique, pour chaque angle d'incidence $\alpha$ fixe (et différent de 90°), on peut prévoir plusieurs implantations successives sous l'angle d'incidence $\alpha$, avec la même énergie d'implantation, en modifiant à chaque fois l'angle, dans un plan parallèle au plan moyen du substrat, entre la source d'émission du faisceau d'ions et l'axe normal central du substrat 100, appelé ci-après angle horizontal ou azimut. Pour modifier l'angle horizontal, on peut par exemple appliquer au substrat une rotation autour de son axe normal central. En variante, pour chaque angle d'incidence $\alpha$, la rotation du substrat autour de son axe normal central peut être continue, par exemple avec une vitesse de rotation constante, pendant toute la durée de l'implantation.

Par ailleurs, bien que l'on ait décrit ci-dessus un exemple de réalisation dans lequel l'angle d'incidence $\alpha$ varie par paliers entre les implantations successives, on pourra prévoir une variation continue de l'angle d'incidence $\alpha$, selon un balayage angulaire déterminé, de préférence en modifiant aussi l'énergie d'implantation de façon continue pour que la profondeur d'implantation Rp soit sensiblement la même pour tous les angles $\alpha$ parcourus.

A titre de variante, on pourra prévoir d'implanter les ions sous un unique angle d'incidence $\alpha$ et avec une même énergie d'implantation, mais sous des angles horizontaux respectifs différents. Là encore, ceci permet de réduire la rugosité de l'interface entre les parties supérieure 100A et inférieure 100B du substrat par rapport à la rugosité de la face supérieure du substrat 100. Là encore, pour modifier l'angle horizontal, on peut par exemple appliquer au substrat une rotation autour de son axe normal central, la rotation pouvant être soit une rotation par paliers discrets, soit une rotation continue pendant toute la durée de l'implantation.

Ainsi, dans la présente description, on entend par orientation d'implantation une combinaison d'un angle d'incidence $\alpha$ et d'un angle horizontal du faisceau d'implantation par rapport au plan moyen du substrat 100. Par plusieurs étapes successives d'implantation ionique avec des orientations d'implantation respectives différentes, on entend que, à chaque nouvelle étape, on modifie l'angle d'incidence et/ou l'angle horizontal du faisceau d'implantation par rapport à l'étape d'implantation précédente, étant entendu que les modifications d'angle peuvent être discontinues (par paliers) ou continues. Si l'angle d'incidence $\alpha$ est modifié, l'énergie d'implantation est de préférence modifiée en conséquence, de façon à maintenir la profondeur d'implantation Rp sensiblement constante. Si seul l'angle horizontal du faisceau d'implantation est modifié, l'énergie d'implantation reste inchangée. Ainsi, la profondeur d'implantation reste sensiblement la même pour toutes les étapes d'implantation de l'étape d'implantation multiple de la figure 2.

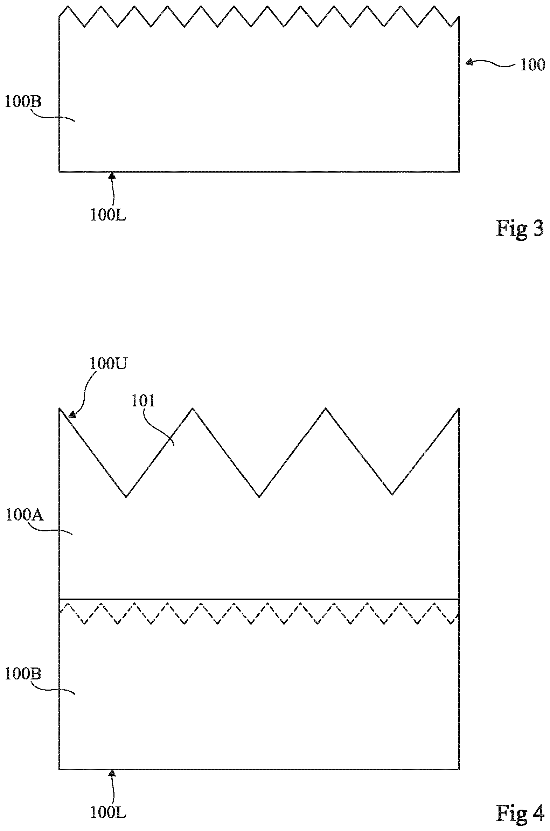

La figure 3 illustre une étape postérieure à l'étape d'implantation multiple de la figure 2. Lors de cette étape, on retire la partie supérieure modifiée 100A du substrat 100 de façon sélective par rapport à la partie inférieure non modifiée 100B du substrat 100. A l'issue de cette étape, seule la partie inférieure 100B du substrat 100 est conservée. Comme expliqué ci-dessus, la face supérieure de la partie 100B du substrat 100 présente une rugosité plus faible que celle de la face supérieure 100U du substrat initial. Ainsi, la combinaison des étapes des figures 2 et 3 a permis de polir la face supérieure du substrat 100.

Le retrait sélectif de la partie supérieure 100A du substrat par rapport à la partie inférieure 100B est rendu possible par la différence de structure (structure cristalline versus structure amorphe) et/ou de composition chimique entre les deux parties. Le retrait de la partie supérieure 100A du substrat peut être effectué par tout procédé de gravure sélective adapté, par exemple par un procédé de gravure à base de composés gazeux, par exemple des composés gazeux contenant des atomes de chlore. A titre d'exemple, dans le cas d'un substrat 100 en silicium monocristallin et d'une implantation conduisant à rendre amorphe la partie supérieure 100A du substrat, la partie amorphe 100A du substrat 100 peut être retirée de façon sélective par rapport à la partie monocristalline 100B par un procédé de gravure sélective au moyen d'un mélange gazeux à base d'acide chlorhydrique (HCl) et de germane ($GeH_4$). Les modes de réalisation décrits ne se limitent toutefois pas à ce cas particulier. Plus généralement, la personne du métier saura choisir un procédé de gravure sélective adapté en fonction de la nature des matériaux des parties 100A et 100B, notamment une gravure humide ou plasma.

La figure 4 est une vue en coupe schématique et partielle illustrant une variante du procédé de polissage décrit ci-dessus en relation avec les figures 1 et 2.

La figure 4 illustre plus particulièrement une étape intermédiaire entre l'étape d'implantation multiple de la figure 2 et l'étape de retrait sélectif de la partie supérieure modifiée 100A du substrat 100. Dans cet exemple, on considère que l'implantation multiple mise en oeuvre à l'étape de la figure 2 a conduit à rendre amorphe la partie supérieure 100A du substrat 100, tandis que la partie inférieure 100B du substrat 100 est restée monocristalline.

Lors de l'étape de la figure 4, on applique un recuit de recristallisation en phase solide à la structure obtenue à l'issue de l'étape d'implantation multiple de la figure 2. Ceci conduit à initier une recristallisation épitaxiale de la partie amorphe 100A du substrat, en partant de la face supérieure de la partie cristalline 100B du substrat. Au début de la phase de recristallisation épitaxiale, l'interface entre la partie cristalline 100B et la partie amorphe 100A du substrat tend à s'aplanir. Ceci conduit à atténuer ou éliminer les rugosités de la face supérieure de la couche cristalline 100B. Ce phénomène est illustré par la figure 4, sur laquelle les rugosités initiales (i.e. avant le recuit de recristallisation en phase solide) de la face supérieure de la couche cristalline 100B ont été représentées en traits interrompus. Le recuit est ensuite interrompu de façon à conserver une partie supérieure 100A de substrat amorphe.

La température de recuit est choisie suffisamment basse pour ne pas induire de nucléation hétérogène dans la partie amorphe 100A, et suffisamment haute pour permettre une recristallisation épitaxiale à partir de la face supérieure de la partie 100B. A titre d'exemple, dans le cas d'un substrat 100 en silicium, la température de recuit peut être comprise entre 470 et 600°C, par exemple de l'ordre de 530°C. La durée du recuit est par exemple comprise entre 1 et 30 minutes, par exemple de l'ordre de 10 minutes.

La partie supérieure amorphe 100A du substrat peut ensuite être retirée sélectivement de façon identique ou similaire à ce qui a été décrit précédemment en relation avec la figure 3.

Ainsi, la variante de la figure 4 permet de réduire encore davantage les rugosités de la face supérieure du substrat 100.

Dans l'exemple décrit ci-dessus, le recuit de recristallisation en phase solide est réalisé avant l'étape de retrait sélectif de la partie supérieure amorphe 100A du substrat, et est décorrélé de ladite étape de retrait sélectif.

A titre de variante, l'étape de recristallisation en phase solide et l'étape de retrait sélectif de la partie supérieure amorphe 100A du substrat peuvent être combinées. Pour cela, la température de gravure sera choisie sensiblement égale à la température de recristallisation en phase solide du matériau amorphe de la partie supérieure 100A du substrat, par exemple, pour du silicium, comprise entre 470 et 600°C, par exemple de l'ordre de 530°C.

Le procédé de gravure peut par exemple comprendre les étapes successives suivantes :

- montée en température et stabilisation à une température T1 sensiblement égale à la température de recristallisation en phase solide, par exemple de l'ordre de 500°C pour un substrat en silicium, par exemple sous flux de dihydrogène (H2) ;
- gravure à la température T1, par un mélange gazeux adapté au matériau de la partie supérieure amorphe 100A du substrat, par exemple un mélange d'acide chlorhydrique et de germane (avec éventuellement un flux additionnel de dihydrogène) pour un substrat en silicium ; et
- descente rapide à une température T2 inférieure à la température de recristallisation en phase solide, par exemple de l'ordre de 450°C pour un substrat en silicium, par exemple sous flux de dihydrogène.

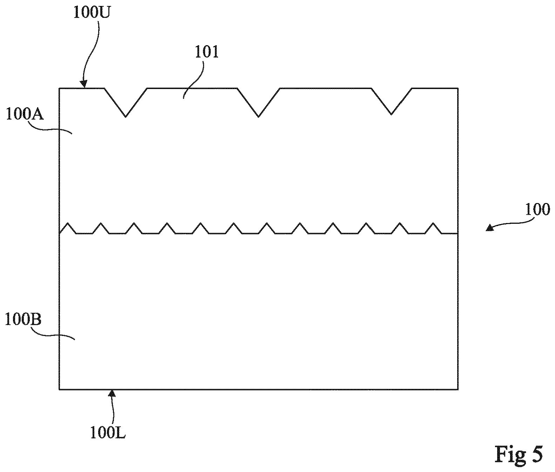

La figure 5 est une vue en coupe schématique et partielle illustrant une autre variante du procédé de polissage décrit ci-dessus.

La figure 5 illustre plus particulièrement une variante de l'étape d'implantation multiple de la figure 2.

Dans cette variante, les étapes successives d'implantation sont réalisées au moyen de faisceaux d'ions relativement lourds et avec des doses d'implantation relativement élevées. Dans ces conditions, on observe un effet de pulvérisation ou abrasion mécanique de la face supérieure 100U du substrat 100. Ceci conduit à polir au moins partiellement les rugosités de la face supérieure du substrat 100. En conséquence, les rugosités répliquées sur la face supérieure de la région inférieure non modifiée 100B du substrat sont réduites par rapport à une implantation ionique n'entraînant pas d'abrasion mécanique de la face supérieure du substrat.

A l'issue de cette étape, la partie supérieure amorphe 100A du substrat peut être retirée sélectivement de façon identique ou similaire à ce qui a été décrit précédemment en relation avec la figure 3.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les modes de réalisation décrits ne se limitent pas aux exemples de valeurs numériques ni aux exemples de matériaux mentionnés dans la description.

En outre, on notera que les procédés de polissage décrits ci-dessus peuvent être appliqués soit sur toute la surface supérieure du substrat 100, soit de façon localisée sur une partie seulement de la surface supérieure du substrat 100. Dans ce dernier cas, un masque, non représenté, peut être disposé sur la face supérieure du substrat 100 lors de l'étape d'implantation ionique multiple, délimitant la zone à polir.

On notera par ailleurs que les variantes décrites en relation avec les figures 4 et 5 peuvent être combinées.

Enfin, la mise en oeuvre pratique des modes de réalisation et variantes décrits est à la portée de la personne du métier à partir des indications fonctionnelles données ci-dessus.

## Revendications

1. Procédé de polissage d'au moins une zone d'un substrat semiconducteur (100), comprenant :

   a) une étape d'implantations multiples d'ions à partir d'une face supérieure (100U) du substrat, de façon à modifier le matériau semiconducteur du substrat dans une partie supérieure (100A) de ladite zone du substrat, l'étape d'implantations multiples comprenant plusieurs implantations successives sous des orientations d'implantation respectives différentes ; et
   b) une étape de retrait sélectif de la partie supérieure (100A) du substrat,

   dans lequel, à l'issue de l'étape a), la partie supérieure (100A) forme une couche continue en le matériau semiconducteur modifié, s'étendant sur toute la surface de ladite au moins une zone du substrat.

2. Procédé selon la revendication 1, dans lequel l'étape d'implantations multiples comprend au moins trois implantations successives sous des orientations d'implantation respectives différentes.

3. Procédé selon la revendication 1 ou 2, dans lequel lesdites implantations successives mises en oeuvre à l'étape a) sont réalisées avec une même profondeur d'implantation (Rp) dans une direction normale au plan moyen du substrat.

4. Procédé selon l'une quelconque des revendications 1 à 3, dans lequel l'étape a) comprend plusieurs implantations successives sous des angles d'incidence ($\alpha$) respectifs distincts et avec des énergies d'implantations respectives distinctes.

5. Procédé selon l'une quelconque des revendications 1 à 4, dans lequel l'étape a) comprend plusieurs implantations successives sous un même angle d'incidence ($\alpha$) et avec une même énergie d'implantation, sous des angles respectifs différents dans un plan parallèle au plan moyen du substrat.

6. Procédé selon l'une quelconque des revendications 1 à 5, dans lequel le substrat (100) est un substrat monocristallin.

7. Procédé selon la revendication 6, dans lequel l'étape a) conduit à rendre amorphe ladite partie supérieure (100A) de ladite au moins une zone du substrat.

8. Procédé selon la revendication 7, comprenant en outre, après l'étape a), une étape de recristallisation en phase solide d'une partie inférieure de ladite partie supérieure (100A) de ladite au moins une zone du substrat (100).

9. Procédé selon la revendication 8, dans lequel ladite étape de recristallisation en phase solide est mise en oeuvre avant l'étape b).

10. Procédé selon la revendication 8, dans lequel ladite étape de recristallisation en phase solide est mise en oeuvre conjointement à l'étape b).

11. Procédé selon la revendication 6, dans lequel l'étape a) conduit à doper ladite partie supérieure (100A) de ladite au moins une zone du substrat en conservant sa structure monocristalline.

12. Procédé selon l'une quelconque des revendications 1 à 11, dans lequel les ions implantés à l'étape a) sont des ions du groupe comprenant l'azote, l'oxygène, le fluor, le silicium, l'argon, le germanium, le xénon, le carbone et le phosphore.

13. Procédé selon l'une quelconque des revendications 1 à 12, dans lequel, à l'étape b), le retrait sélectif de la partie supérieure (100A) de ladite au moins une zone du substrat est réalisé par un procédé de gravure thermique à l'aide d'un mélange gazeux.

14. Procédé selon la revendication 13, dans lequel le substrat semiconducteur (100) est en silicium, et dans lequel le mélange gazeux est un mélange à base d'acide chlorhydrique et de germane, avec un éventuel flux additionnel de dihydrogène.

15. Procédé selon l'une quelconque des revendications 1 à 14, dans lequel, à l'étape a), les conditions d'implantation sont choisies adaptées à entraîner une abrasion mécanique de la face supérieure du substrat.


**Patentansprüche**

1. Verfahren zum Polieren mindestens eines Bereichs eines Halbleitersubstrats (100), wobei das Verfahren Folgendes aufweist:

   a) einen Schritt der mehrfachen Implantierens von Ionen von einer oberen Oberfläche (100U) des Substrats, um das Halbleitermaterial des Substrats in einem oberen Teil (100A) des Bereichs des Substrats zu modifizieren, wobei der Schritt des mehrfachen Implantierens eine Vielzahl von aufeinanderfolgenden Implantierungen unter verschiedenen jeweiligen Implantierausrichtungen aufweist; und
   b) einen Schritt des selektiven Entfernens des oberen Teils (100A) des Substrats,

   wobei am Ende von Schritt a) der obere Teil (100A) eine kontinuierliche Schicht des modifizierten Halbleitermaterials bildet, die sich über die gesamte Oberfläche des mindestens einen Bereichs des Substrats erstreckt.

2. Verfahren nach Anspruch 1, wobei der Schritt des mehrfachen Implantierens mindestens drei aufeinanderfolgende Implantierungen mit jeweils unterschiedlichen Implantierausrichtungen aufweist.

3. Verfahren nach Anspruch 1 oder 2, wobei die in Schritt a) durchgeführten aufeinanderfolgenden Implantierungen mit einer gleichen Implantiertiefe (Rp) in einer Richtung senkrecht zur mittleren Ebene des Substrats durchgeführt werden.

4. Verfahren nach einem der Ansprüche 1 bis 3, wobei Schritt a) mehrere aufeinanderfolgende Implantierungen unter jeweils unterschiedlichen Einfallswinkeln ($\alpha$) und mit jeweils unterschiedlichen Implantierenergien aufweist.

5. Verfahren nach einem der Ansprüche 1 bis 4, wobei Schritt a) mehrere aufeinanderfolgende Implantierungen unter demselben Einfallswinkel ($\alpha$) und mit derselben Implantationsenergie unter jeweils unterschiedlichen Winkeln in einer Ebene parallel zur mittleren Ebene des Substrats aufweist.

6. Verfahren nach einem der Ansprüche 1 bis 5, wobei das Substrat (100) ein einkristallines Substrat ist.

7. Verfahren nach Anspruch 6, wobei Schritt a) zu einer Amorphisierung des oberen Teils (100A) des mindestens einen Bereichs des Substrats führt.

8. Verfahren nach Anspruch 7, ferner aufweisend nach Schritt a) einen Schritt der Festkörper-Rekristallisation eines unteren Teils des oberen Teils (100A) des mindestens einen Bereichs des Substrats (100) .

9. Verfahren nach Anspruch 8, wobei die Festkörper-Rekristallisationsphase vor Schritt b) durchgeführt wird.

10. Verfahren nach Anspruch 8, wobei der Festkörper-Rekristallisationsschritt gemeinsam mit Schritt b) durchgeführt wird.

**11.** Verfahren nach Anspruch 6, wobei Schritt a) zu einer Dotierung des oberen Abschnitts (100A) des mindestens einen Bereichs des Substrats führt, während dessen einkristalline Struktur erhalten bleibt.

**12.** Verfahren nach einem der Ansprüche 1 bis 11, wobei die in Schritt a) implantierten Ionen Ionen aus der Gruppe sind, die Stickstoff, Sauerstoff, Fluor, Silizium, Argon, Germanium, Xenon, Kohlenstoff und Phosphor aufweist.

**13.** Verfahren nach einem der Ansprüche 1 bis 12, wobei in Schritt b) das selektive Entfernen des oberen Teils (100A) des mindestens einen Bereichs des Substrats durch ein Verfahren des thermischen Ätzens mittels eines Gasgemischs durchgeführt wird.

**14.** Verfahren nach Anspruch 13, wobei das Halbleitersubstrat (100) aus Silizium besteht, und wobei das Gasgemisch ein Gemisch auf Basis von Salzsäure und Germaniumwasserstoff mit einem möglichen zusätzlichen Wasserstoffstrom ist.

**15.** Verfahren nach einem der Ansprüche 1 bis 14, wobei in Schritt a) die Implantierbedingungen so gewählt werden, dass sie einen mechanischen Abrieb der oberen Oberfläche des Substrats verursachen.

**Claims**

**1.** Method of polishing at least one area of a semiconductor substrate (100), comprising:

a) a step of multiple implantations of ions from an upper surface (100U) of the substrate, to modify the semiconductor material of the substrate in an upper portion (100A) of said area of the substrate, the multiple implantation step comprising a plurality of successive implantations under different respective implantation orientations; and
b) a step of selective removal of the upper portion (100A) of the substrate,

wherein, at the end of step a), the upper portion (100A) forms a continuous layer of the modified semiconductor material extending all over the surface of said at least one area of the substrate.

**2.** Method according to claim 1, wherein the multiple implantation step comprises at least three successive implantations under different respective implantation orientations.

**3.** Method according to claim 1 or 2, wherein said successive implantations implemented at step a) are carried out with a same implantation depth (Rp) in a direction normal to the mean plane of the substrate.

**4.** Method according to any of claims 1 to 3, wherein step

a) comprises a plurality of successive implantations under different respective angles of incidence ($\alpha$) and with different respective implantation energies.

**5.** Method according to any of claims 1 to 4, wherein step

a) comprises a plurality of successive implantations under a same angle of incidence ($\alpha$) and with a same implantation energy, under different respective angles in a plane parallel to the mean plane of the substrate.

**6.** Method according to any of claims 1 to 5, wherein the substrate (100) is a single-crystal substrate.

**7.** Method according to claim 6, wherein step a) results in amorphizing said upper portion (100A) of said at least one area of the substrate.

**8.** Method according to claim 7, further comprising, after step a), a step of solid state recrystallization of a lower portion of said upper portion (100A) of said at least one area of the substrate (100).

**9.** Method according to claim 8, wherein said solid phase recrystallization phase is implemented before step b) .

10. Method according to claim 8, wherein said solid phase recrystallization step is implemented jointly to step b) .

11. Method according to claim 6, wherein step a) results in doping said upper portion (100A) of said at least one area of the substrate while keeping its single-crystal structure.

12. Method according to any of claims 1 to 11, wherein the ions implanted at step a) are ions from the group comprising nitrogen, oxygen, fluorine, silicon, argon, germanium, xenon, carbon, and phosphorus.

13. Method according to any of claims 1 to 12, wherein, at step b), the selective removal of the upper portion (100A) of said at least one area of the substrate is carried out by a method of thermal etching by means of a gaseous mixture.

14. Method according to claim 13, wherein the semiconductor substrate (100) is made of silicon, and wherein the gaseous mixture is a mixture based on hydrochloric acid and on germane, with a possible additional hydrogen stream.

15. Method according to any of claims 1 to 14, wherein, at step a), the implantation conditions are selected to be adapted to causing a mechanical abrasion of the upper surface of the substrate.

Fig 1

Fig 2

100

100B

100L

Fig 3

100U

101

100A

100B

100L

Fig 4

Fig 5

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2014037410 A
- US 2018350612 A
- JP H03190233 B